# EUROPÄISCHE PATENTSCHRIFT

(11) **EP 0 931 295 B1**
(45) Veröffentlichungstag und Bekanntmachung des Hinweises auf die Patenterteilung: **12.12.2001**
(21) Anmeldenummer: 97909306.9
(22) Anmeldetag: 22.09.1997
(51) Int. Cl.: G06K 19/077

(54) **VERFAHREN UND VERBINDUNGSANORDNUNG ZUM HERSTELLEN EINER CHIPKARTE**
METHOD AND CONNECTION ARRANGEMENT FOR PRODUCING A SMART CARD
PROCEDE ET SYSTEME DE CONNEXION POUR PRODUIRE UNE CARTE A PUCE

(30) Priorität: 09.10.1996 DE 19641650; 31.10.1996 DE 19645067
(43) Veröffentlichungstag der Anmeldung: 28.07.1999
(73) Patentinhaber: PAV Card GmbH, 22952 Lütjensee (DE); SIEMENS AKTIENGESELLSCHAFT, 80333 München (DE); EVC Rigid Film GmbH, 79219 Staufen (DE)
(72) Erfinder: WILM, Robert, D-22929 Kasseburg (DE); HOUDEAU, Detlef, D-84085 Langquaid (DE); REINER, Robert, D-82008 Unterhaching (DE); RETTIG, Rainer, D-79224 Umkirch (DE)
(74) Vertreter: Kruspig, Volkmar, Dipl.-Ing.
(86) Internationale Anmeldenummer: EP9705197
(87) Internationale Veröffentlichungsnummer: WO9815916

(56) Entgegenhaltungen:
- EP-A- 0 326 822
- DE-A- 19 500 925
- NL-A- 9 100 176
- NL-A- 9 100 347

## Beschreibung

Die Erfindung betrifft ein Verfahren zum Herstellen einer Chipkarte sowie eine Verbindungsanordung zur Herstellung einer derartigen Chipkarte gemäß Oberbegriff des Patentanspruches 1 bzw. 3.

Bei einem bekannten Verfahren zur Herstellung einer Chipkarte, insbesondere solcher, bei der sowohl Mittel zur kontaktlosen Datenübertragung als auch eine galvanische Kontaktebene vorhanden ist, wird in einen Kartenkörper ein Modul eingebracht, welcher einen Halbleiterchip umfaßt.

Der Modul wird vorzugsweise in eine Ausnehmung im Kartenkörper eingelegt und mittels Fügen oder dergleichen mit dem Kartenkörper unter Erhalt einer entsprechenden mechanischen und elektrischen Verbindung laminiert.

Eine elektrisch leitende Verbindung zwischen Modul und Kartenkörper bzw. auf dem Kartenkörper befindlichen Kontakten, die mit einer Spule zur Herstellung einer kontaktlosen Verbindung zur Umgebung in Kontakt stehen, kommt beispielsweise dadurch zustande, daß ein anisotroper leitender Klebstoff im Bereich der Anschlußstellen und/oder der Verbindungsstellen des jeweiligen Mittels für eine kontaktlose Datenübertragung aufgetragen und der Klebstoff zumindest im Bereich der Anschlußstellen soweit verdichtet oder komprimiert wird, daß eine elektrisch leitende Brücke entsteht.

Im Fall eines Klebstoffes mit leitenden Partikeln führt zu dies dazu, daß die Partikel im Bereich zwischen den Anschlußstellen und dem Mittel für die kontaktlose Datenübertragung sich berühren, wodurch die leitende Verbindung resultiert.

Die bei der Herstellung von Chipkarten verwendeten Module greifen in der Regel auf einen Kunststoffträger zurück, auf dem das eingangs erwähnte Halbleiterchip gegebenenfalls mit ISO-Kontaktflächen versehen angeordnet ist. Das so vorgefertigte Modul wird mit dem Kartenträger, der z.B. aus Polycarbonat bestehen kann, verbunden. Dieses Verbinden bzw. das Einsetzen des Moduls in den Kartenkörper in eine, z.B. gefräste, Ausnehmung erfolgt üblicherweise unter Rückgriff auf ein Klebeverfahren bei Verwendung eines Heiß- oder Schmelzklebers.

In dem Falle, wenn Kombikarten, die sowohl zur kontaktlosen als auch zur kontaktbehafteten Verwendung geeignet sind, oder kontaktlose Karten hergestellt werden sollen, muß eine weitere Kontaktebene mit Anschlußstellen für die Induktionsschleife vorgesehen sein. Diese Anschlußstellen befinden sich bevorzugt erhaben auf der Oberfläche des Moduls und/oder auf der Oberfläche oder an den Seitenflächen der Ausnehmung des Kartenträgers. Bei derartigen Anordnungen ist es dann möglich, die Verklebung von Modul- und Kartenträgern mittels der Herstellung der elektrisch leitenden Verbindung in einem Arbeitsgang durchzuführen. Es hat sich jedoch gezeigt, daß das erforderliche Temperatur- und Zeitregime zur Herstellung zuverlässiger sowohl elektrischer als auch mechanischer Verbindungen engen Toleranzen unterliegt, so daß bei nicht optimalen Verfahrensparametern die Langzeitstabilität derartig hergestellter Karten reduziert ist und das es aufgrund der Abmessungen und der plastischen Eigenschaften des Moduls sowie des Kartenträgers zur Verwindungen und Verspannungen in der Karte mit der Folge gestörter elektrischer Verbindungen, d.h. geringerer Zuverlässigkeit kommt.

Gleiches gilt für kraftschlüssige Verbindungen, z.B. mittels Federelement. Hier können zwar Verspannungen oder Verwindungen durch Kontakt-Federelemente aufgenommen werden, jedoch bestehen Probleme hinsichtlich der Oberflächenkorrosion der Kontakte.

Aus der NL-A-9100347 ist eine Chipkarte mit einem auf einem Modul in einer Ausnehmung eines Kartenträgers befindlichen Halbleiterchip bekannt. Der Modul ist mit einer ersten Spule versehen, wobei diese erste Spule über ein Kernmaterial induktiv verbunden mit einer zweiten Spule ist, die mit einer Antennenspule kontaktiert wird. Die dort gezeigten beiden Spulen sind lateral versetzt angeordnet. Durch den Einsatz eines speziellen Kernmaterials ist das dortige Herstellungsverfahren sehr aufwendig, wobei ein weiterer Nachteil im hohen Flächenbedarf bedingt durch die laterale Anordung liegt.

Es ist Aufgabe der Erfindung, ein Verfahren zur Herstellung einer Chipkarte sowie eine Verbindungsanordnung für ein derartiges Herstellungsverfahren anzugeben, mit welchem ein auf einem Modul befindlicher Halbleiterchip in eine Ausnehmung eines Kartenkörpers sowohl elektrisch als auch mechanisch mit hoher Zuverlässigkeit kontaktiert werden kann, wobei die resultierende Gesamtanordnung eine hohe Langzeitstabilität und Zuverlässigkeit der Chipkarte gewährleisten soll.

Die Lösung der Aufgabe der Erfindung erfolgt mit einem Verfahren nach Patentanspruch 1 sowie mit einer Verbindungsanordnung gemäß den Merkmalen des Patentanspruches 3, wobei die Unteransprüche zweckmäßige Ausgestaltungen oder Weiterbildungen umfassen.

In einer Ausführungsform der Erfindung weist der in die Kartenausnehmung zu implantierende Modul eine erste Spule auf, wobei diese erste Spule mit in einer an oder in der Ausnehmung des Kartenträgers befindlichen zweiten Spule induktiv verbunden ist. Die zweite Spule steht dann in an sich bekannter Weise mit einer in der Chipkarte befindlichen dritten (Antennen-) Spule zur Herstellung einer kontaktlosen Verbindung zur Umgebung hin in Kontakt. Die zweite und dritte Spule können auch eine gemeinsame Spule bilden.

In einer bevorzugten Weiterbildung der Erfindung ist der das Chip tragende Modul mit einer speziellen Metallisierungsebene versehen, die als Induktionsspule ausgeführt ist. Diese Induktionsspule wird bei der Montage des Moduls in der Ausnehmung der Kontaktfläche mit einer in der Ausnehmung befindlichen Spule zur induktiven Kopplung in Deckung gebracht. Die in der Ausnehmung des Kartenträgers befindliche Spule kann Bestandteil der an sich bekannten Induktionsspule zur elektrischen Kontaktierung nach außen sein.

Erfindungsgemäß wird zur Erhöhung des Kopplungsgrades zwischen den induktiven Elementen, d.h. der ersten und zweiten Spule vorgeschlagen, den Modul mindestens teilweise und/oder den Kartenträger im Bereich der zweiten Spule mit hochpermeablen Dotierungsstoffen zu versehen oder eine hochpermeable Beschichtung aufzubringen. Vorzugsweise sind hierfür auf eine entsprechende Korngröße gebrachte, fein granulierte Seltenerdemagnete einsetzbar. Auch an sich bekannte Titanate und Ferritmaterialien sind zur Erhöhung der Permeabilität geeignet.

Es liegt im Sinne der Erfindung, daß die ersten und zweiten Spulen sowohl als Drahtspule oder in gedruckter oder additiv aufgebrachter Form realisierbar sind. Auch ist das Herausätzen von Spulenwindungen oder das Herausbrennen aus einer Metallisierungsschicht durch Verwendung eines Lasers denkbar.

Die im Modul vorhandene erste Spule kann auf der zum Kartenträger nach innen hingerichteten Seite aufgebracht aber auch auf einem Zwischenträger befindlich sein, der mit einer entsprechenden Isolationszwischenschicht der Aufnahme von ISO-Außenkontakten dient.

Anordnungsseitig wird zur Herstellung einer Chipkarte bestehend aus einem Modul mit einem Halbleiterchip sowie einem Kartenträger mit Ausnehmung zur Aufnahme des Moduls auf oder in der Einsatzseite des Moduls eine erste Spule ausgebildet, welche mit Anschlüssen des Halbleiterchips elektrisch verbunden ist. In oder auf der Ausnehmung des Kartenträgers befindet sich eine zweite Spule, wobei sich nach dem Einsetzen des Moduls in die Ausnehmung des Kartenträgers eine gewünschte induktive Kopplung zwischen erster und zweiter Spule einstellt. Die zweite Spule steht in Verbindung mit einer dritten Spule zur Herstellung einer kontaktlosen Verbindung zur Umgebung. Es liegt im Sinne der Erfindung, daß die zweite und dritte Spule als eine einheitliche Spule mit unterschiedlichen Windungsabschnitten ausgebildet sein können, wobei ein kleinerer Windungsabschnitt im Bereich der Ausnehmung befindlich ist und ein größerer Windungsabschnitt in einem äußeren Randabschnitt des Kartenträgers verläuft.

Die erste Spule ist als Versteifungsrahmen wirkend außenrandseitig des Moduls angeordnet. Hierdurch erhöht sich die Steifigkeit des Moduls, wodurch Preßkräfte insbesondere beim Laminieren des Moduls in die Ausnehmung des Kartenträgers besser aufgenommen werden können.

Die Erfindung soll nachstehend anhand eines Ausführungsbeispieles und unter Zuhilfenahme von Figuren näher erläutert werden.

Hierbei zeigen:
- Fig. 1: eine prinzipielle perspektivische Darstellung eines Kartenträgers mit Ausnehmung zur Aufnahme eines Chipmoduls;
- Fig. 2: eine Ansicht eines Chipmoduls mit Ausbildung einer Induktionsspule;
- Fig. 3: eine prinzipielle Darstellung der Chipkarte mit Spule zur Herstellung einer kontaktlosen Verbindung zur Umgebung hin und innerer Spule zur induktiven Kopplung mit der auf dem Chipmodul befindlichen weiteren Spule
und
- Fig. 4 a-c: verschiedene Varianten eines Moduls mit induktivem Koppelelement.

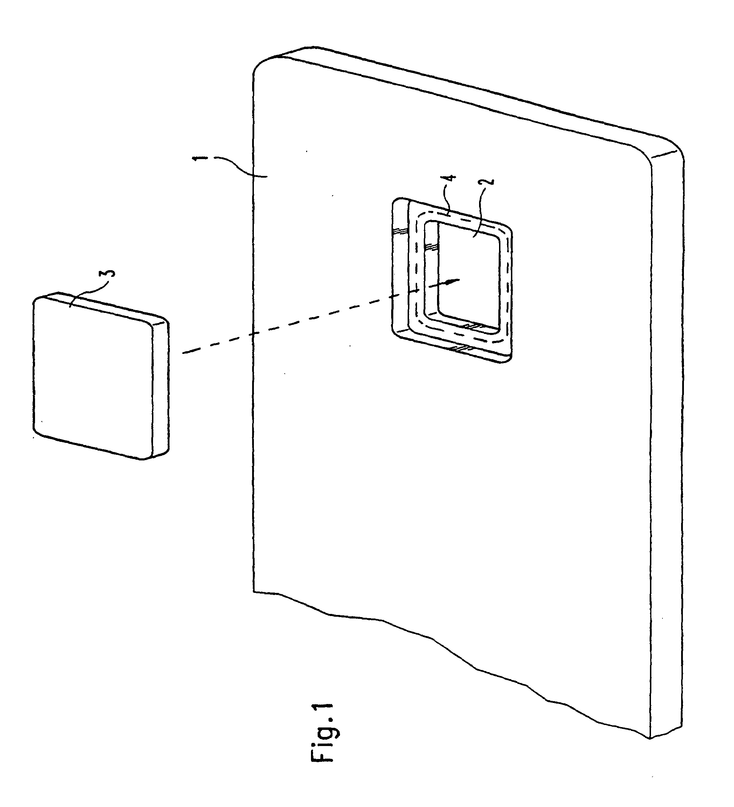

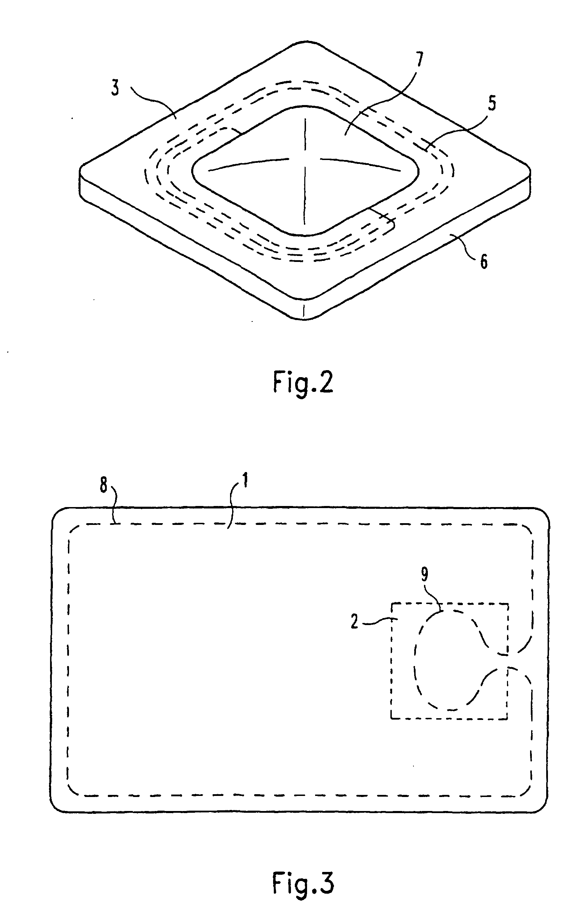

Bei der in der Figur 1 gezeigten Darstellung wird von einer IC-Karte 1 ausgegangen, welche eine Ausnehmung 2 zur Aufnahme eines Chipmodules 3 aufweist. Im Bereich der Ausnehmung 2 der IC-Karte 1 ist eine zweite Spule 4 auf- bzw. eingebracht, die der induktiven Kopplung mit einer ersten Spule 5 (Figur 2) dient.

Für das Einsetzen und Chipkontaktieren des Moduls 3 in die Ausnehmung 2 kann auf an sich bekannte Laminier- und Klebetechniken zurückgegriffen werden. Im Gegensatz zum Bekannten, wird jedoch gemäß Ausführungsbeispiel die gewünschte elektrische Verbindung zwischen Chipmodul 3 und der zweiten Spule 4 in der IC-Karte 1 rein induktiv realisiert. Mechanische Spannungen oder minimale Veränderungen der Lagebeziehung zwischen IC-Karte 1 und Chipmodul 3 führen nicht zu schlechteren elektrischen Verbindungen, beispielsweise durch Erhöhung des Kontaktwiderstandes an den Verbindungspunkten zwischen Modul und Antenne.

Bei dem Chipmodul 3 gemäß Figur 2 wird von einem bekannten Substratträger 6 ausgegangen, welcher mit einem sogenannten Nackt-Chip versehen ist. Darüber hinaus ist auf dem Substratträger 6 die erste Spule 5 auf- oder eingebracht, welche elektrisch mit den entsprechenden Anschlüssen des Chips verbunden ist. Der Chip selbst wird mit einer Abdeckung 7, z.B. aus Silikongummi, versehen.

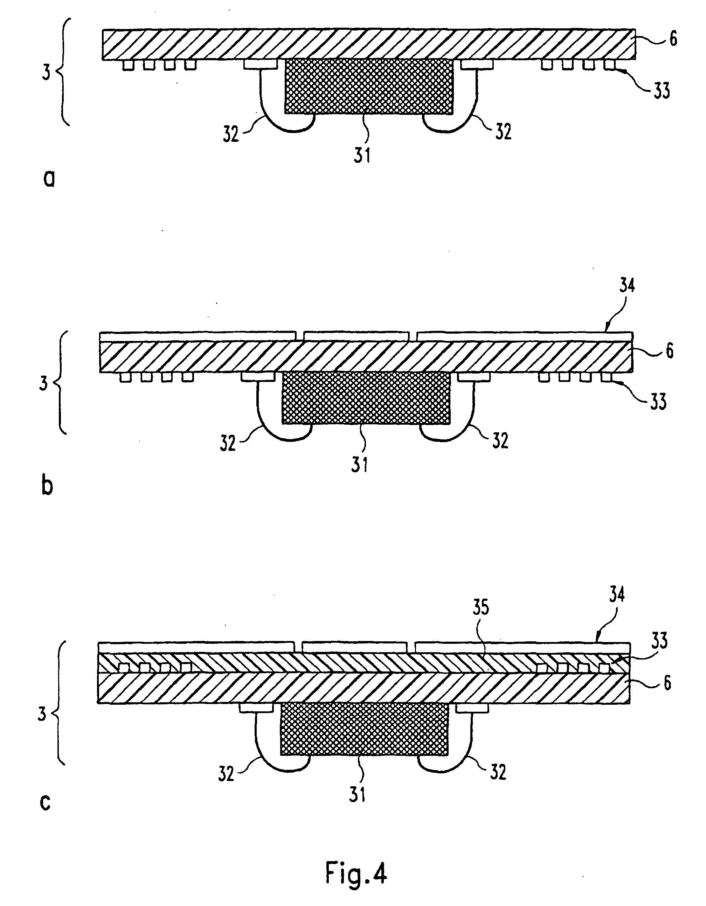

Der Substratträger 6 kann auf seiner dem Chip gegenüberliegenden Seite mit an sich bekannten ISO-Kontakten zur kontaktbehafteten Verbindung nach außen versehen sein. Hier wird ergänzend auf die Figuren 4b und 4c verwiesen.

Eine vorteilhafte Ausbildung der IC-Karte 1 mit einer induktiven Koppelspule zur Herstellung einer drahtlosen Verbindung zur Umgebung hin sei anhand der Figur 3 erläutert.

Die äußere induktive Koppelspule 8 weist einen Spulenabschnitt 9 auf, welcher die zweite Spule 4 im Bereich der Ausnehmung 2 bildet.

Figur 4a zeigt eine Querschnittsdarstellung eines Chipmodules 3 mit Chip 31, Chipkontakten 32 und Spulenwindungen 33. Dieses Modul wird Facedown in die entsprechende Ausnehmung 2 der IC-Karte 1 eingesetzt, wobei gegebenenfalls die Spulenwindungen 33 bezogen auf die gegenüberliegende Windungen der zweiten Spule 4 isoliert sind.

Bei der Ausführungsform gemäß Figur 4b ist der Substratträger 6 auf seiner nach oben weisenden, nach außen zeigenden Seite mit ISO-Kontakten 34 versehen, die in nicht näher dargestellter Weise elektrisch mit dem Chip 31 in Verbindung stehen. Die ISO-Kontakte 34 dienen der Herstellung einer kontaktbehafteten Verbindung der IC-Karte nach außen.

Bei der Ausführungsform der Verbindungsanordnung bzw. des Chipmodules 3 nach Figur 4c wird von einem Zwischenträger 35 ausgegangen, der der Aufnahme der Spulenwindungen 33 und der ISO-Kontakte 34 dient. Der Zwischenträger 35 kann wiederum mit dem Substratträger 6, z.B. durch laminieren, verbunden werden. Bei der gezeigten Anordnung gemäß Figur 4c kann auf eine zusätzliche elektrische Isolierung der Spulenwindungen 33 verzichtet werden, da diese entweder im Zwischenträger 35 eingebettet oder durch den Substratträger 6 isoliert werden.

Zur Verbesserung der induktiven Kopplung können Bereiche des Substratträgers, des Zwischenträgers und/oder entsprechende Abschnitte in der Ausnehmung der IC-Karte mit hochpermeablen Stoffbeimengungen versehen sein oder es kann eine entsprechende Beschichtung im Bereich der ersten und zweiten Spulen aufgebracht werden.

Gemäß einem weiteren Ausführungsbeispiel kann die erste Spule des zu implantierenden Moduls als Versteifungsrahmen wirken und in diesem Sinne einen integralen Bestandteil des Chipträgers bilden, so daß Kräfte beim Einpressen des Moduls in die Ausnehmung leichter aufgenommen werden bzw. das Auftreten unerwünschter Verformungen des Moduls beim Einsetzen und Einpressen von vornherein vermieden wird.

Alles in allem gelingt es mit der Erfindung die Nachteile bekannter elektrischer Kontaktierungen stoffschlüssiger oder kraftschlüssiger Art zu vermeiden, in dem auf induktive Kopplung der Signalübertrag zwischen Chip und eigentlicher IC-Karte zurückgegriffen wird. Hierdurch reduzieren sich Aufwendungen bei der Montage des Moduls aufgrund der Vermeidung aufwendiger Justagen und es können die Kosten herstellungsseitig reduziert werden, da die Verwendung teuerer Spezialkleber, die sowohl eine elektrische als auch mechanische Verbindung realisieren sollen, entfallen kann.

## Patentansprüche

1. Verfahren zum Herstellen einer Chipkarte (1) mit einem auf einem Modul (3) befindlichen Halbleiterchip (31), wobei der Modul (3) mit einer ersten Spule (5) versehen wird und diese erste Spule (5) mit einer in der Ausnehmung (2) des Kartenträgers befindlichen zweiten Spule (4) induktiv verbunden ist und die zweite Spule (4) zu einer an sich bekannten, in der Chipkarte (1) befindlichen dritten Spule (8) zur Herstellung einer drahtlosen Verbindung zur Umgebung hin führt, wobei die zweite und dritte Spule als eine einzige Spule ausgebildet sein kann,
**dadurch gekennzeichnet,**
**daß** der Modul (3) in eine Ausnehmung (2) eines Kartenträgers unter Erhalt einer elektrischen und/oder mechanischen Verbindung derart eingesetzt wird, daß die erste und die zweite Spule (5;4) zur induktiven Kopplung zur Deckung gebracht werden.

2. Verfahren nach Anspruch 1,
**dadurch gekennzeichnet,**
**daß** der mit der ersten Spule (5) versehene Modul (3) in die Kartenausnehmung (2) zum Erhalt der mechanischen Verbindung vorzugsweise eingepreßt wird.

3. Verbindungsanordnung zur Herstellung einer Chipkarte (1), bestehend aus einem Modul (3) mit einem Halbleiterchip (31) sowie einem Kartenträger zur Aufnahme des Moduls (3), wobei auf dem Modul (3) eine erste Spule (5) ausgebildet ist, welche mit Anschlüssen des Halbleiterchips (31) elektrisch verbunden ist, und daß auf dem Kartenträger eine zweite Spule (4) aufgebracht oder eingeformt ist, wobei zwischen den Spulen (4;5) eine induktive Kopplung resultiert und das weiterhin eine elektrische Verbindung zu einer dritten (Antennen-) Spule (8) besteht, oder das die zweite Spule ein Teil einer (Antennen-) Spule (8) zur Herstellung einer drahtlosen Verbindung zur Umgebung ist,
**dadurch gekennzeichnet,**
**daß** die erste Spule (5) als Versteifungsrahmen wirkend außenrandseitig des Moduls angeordnet ist, wobei die erste und die zweite Spule (5;4) überdeckend ausgebildet sind.

4. Verbindungsanordnung nach Anspruch 3,
**dadurch gekennzeichnet,**
**daß** der Spulen-Versteifungsrahmen integral mit einem Chipträger oder Zwischenträger (35) ausgebildet ist.

## Claims

1. A method of manufacturing a smart card (1) comprising a semiconductor chip (31) arranged on a module (3), wherein the module (3) is provided with a first coil (5) and this first coil (5) is inductively connected to a second coil (4) arranged in the recess (2) in the card substrate, and the second coil (4) leads to a known, third coil (8) provided in the smart card (1) for producing a wireless connection to the environment, wherein the second and third coils can be formed as a single coil, **characterised in that** the module (3) is inserted into a recess (2) in a card substrate, with maintenance of any electrical and/or mechanical connection, so that the first and second coils (5; 4) are congruently arranged for inductive coupling.

2. A method according to claim 1, **characterised in that** the module (3) provided with the first coil (5) is preferably pressed into the card recess (2) for maintenance of the mechanical connection.

3. A connection arrangement for manufacturing a smart card (1), comprising a module (3) with a semiconductor chip (31) and a card substrate for receiving the module (3), wherein a first coil (5) is formed on the module (3) and is electrically connected to terminals of the semiconductor chip (31), and a second coil (4) is applied to or formed in the card substrate, resulting in inductive coupling between the coils (4; 5), and wherein furthermore an electrical connection to a third (antenna) coil (8) is established or the second coil is part of an (antenna) coil (8) for producing a wireless connection to the environment, **characterised in that** the first coil (5) is arranged on the outer edge of the module and acts as a reinforcing frame, the first and second coils (5; 4) being formed so as to overlap.

4. A connection arrangement according to claim 3, **characterised in that** the coil reinforcing frame is formed integrally with a chip substrate or intermediate substrate (35).

## Revendications

1. Procédé de fabrication d'une carte à puce (1) avec une puce semi-conductrice (31) située sur un module (3), le module étant muni d'une première bobine (5) et cette première bobine (5) étant reliée par induction à une deuxième bobine (4) située dans l'évidement (2) du support de carte, et la deuxième bobine (4) conduisant à une troisième bobine (8) connue en soi et située sur la carte à puce (1) afin d'établir une liaison sans fil avec l'environnement, la deuxième et la troisième bobines pouvant être configurées sous la forme d'une seule bobine,
**caractérisé en ce que** le module (3) est inséré dans un évidement (2) d'un support de carte avec obtention d'une liaison électrique et/ou mécanique de telle manière que la première et la deuxième bobines (5 ; 4) soient mises en chevauchement pour le couplage inductif.

2. Procédé selon la revendication 1, **caractérisé en ce que** le module (3) muni de la première bobine (5) est de préférence pressé dans l'évidement de carte (2) pour obtenir la liaison mécanique.

3. Système d'assemblage pour fabriquer une carte à puce (1) composée d'un module (3) avec une puce semi-conductrice (31), ainsi que d'un support de carte pour recevoir le module (3), une première bobine (5) reliée électriquement à des branchements de la puce semi-conductrice (31) étant formée sur le module (3), et une deuxième bobine (4) étant appliquée ou formée sur le support de carte, un couplage inductif s'établissant entre les bobines (4 ; 5) et une liaison électrique avec une troisième bobine (d'antenne) (8) existant de plus, ou bien la deuxième bobine faisant partie d'une bobine (d'antenne) (8) pour établir une liaison sans fil avec l'environnement, **caractérisé en ce que** la première bobine (5) est placée sur le pourtour extérieur du module avec un effet de cadre de renforcement, la première et la deuxième bobines (5 ; 4) étant formées en chevauchement.

4. Système d'assemblage selon la revendication 3, **caractérisé en ce que** le cadre de renforcement de bobine est formé solidaire d'un support de puce ou support intermédiaire (35).
